# FASCICULE DE BREVET EUROPEEN

(11) **EP 3 097 562 B1**
(45) Date de publication et mention de la délivrance du brevet: **10.01.2018**
(21) Numéro de dépôt: 15700668.5
(22) Date de dépôt: 15.01.2015
(51) Int. Cl.: G11C 11/16, G11C 11/18

(54) **CIRCUIT DE VÉRIFICATION D'INFORMATIONS BINAIRES TELLES QU'UNE CLÉ DE SÉCURITÉ POUR UN DISPOSITIF ÉLECTRONIQUE**
PRÜFUNGSSCHALTUNG FÜR BINÄRE INFORMATIONEN WIE ZUM BEISPIEL EIN SICHERHEITSSCHLÜSSEL FÜR EIN ELEKTRONISCHES GERÄT
CIRCUIT OF VERIFICATION OF BINARY INFORMATIONS SUCH AS A SECURITY KEY FOR AN ELECTRONIC DEVICE

(30) Priorité: 20.01.2014 FR 1450427
(43) Date de publication de la demande: 30.11.2016
(73) Titulaire: Université de Lorraine, 54052 Nancy Cedex (FR); Centre National de la Recherche Scientifique (C.N.R.S.), 75794 Paris Cedex 16 (FR)
(72) Inventeur: HAUET, Thomas, F-54000 Nancy (FR); LACOUR, Daniel, F-54000 Nancy (FR); MONTAIGNE, François, F-54000 Nancy (FR); HEHN, Michel, F-54230 Neuves-Maisons (FR)
(74) Mandataire: Novagraaf Technologies
(86) Numéro de dépôt international: PCT/EP2015/050646
(87) Numéro de publication internationale: WO 2015/107104

(56) Documents cités:
- EP-A1- 1 310 962
- WO-A1-2013/017981

## Description

### Domaine technique

La présente invention se rapporte à un circuit de vérification d'informations binaires telles qu'une clé de sécurité pour un dispositif électronique, en particulier du genre utilisant des cellules de mémorisation magnétiques, comme celui décrit dans une demande de brevet internationale WO 2013/017981A ou dans une demande de brevet européen EP1310962A1.

### Etat de la technique

Les composants électroniques formés de couches ferromagnétiques empilées et nanostructurées sont des dispositifs intégrés permettant potentiellement le stockage et le traitement de l'information sous forme magnétique. Ces dispositifs constituent l'application la plus importante de l'électronique de spin. La lecture des états magnétiques "0" ou "1" est basée sur l'effet de magnétorésistance géante (GMR) ou l'effet tunnel dépendant du spin (TMR) : la résistance électrique des dispositifs appelés dispositifs magnétorésistifs dépend fortement de l'orientation relative des aimantations des couches magnétiques qui les composent.

L'écriture (changer un "0" en "1" ou inversement) fait appel à des procédés permettant de manipuler les états magnétiques à l'échelle du nanomètre. Ces procédés d'écriture sont l'induction locale d'un champ magnétique par un courant électrique, le transfert de spin (interaction entre un courant électrique polarisé en spin et l'aimantation d'une couche ferromagnétique), un échauffement thermique local (généré par un courant via l'effet Joule), un effet de champ électrique, un effet de contrainte mécanique ou l'absorption de photons (lumière) polarisés, ou par une combinaison de ces moyens. Les dispositifs "passifs" de lecture sont exploités comme capteurs de champs magnétiques, comme têtes de
combinaison de ces moyens. Les dispositifs "passifs" de lecture sont exploités comme capteurs de champs magnétiques, comme têtes de
lecture de disques durs, ou encore pour lire l'information stockée au sein d'une mémoire vive magnétique (MRAM).

Une application industrielle de l'électronique de spin a été proposée dans le document US2012/0143889. Il s'agit de composants dédiés au traitement de l'information sous la forme de réseau d'unité logique magnétique. En d'autres termes, ce système électronique doit permettre l'authentification d'une information numérique, par exemple lors de transactions bancaires numériques, lors d'authentification biométrique, ou tout type de contrôle d'accès sécurisés. L'objet d'une unité logique magnétique est donc de comparer un signal binaire donné par un utilisateur à une référence (elle même binaire) mémorisée dans le composant. Une telle unité logique magnétique est formée d'une chaîne d'éléments magnétorésistifs (jonction tunnel magnétique) connectés en série. À chaque élément magnéto-résistif est associée une piste conductrice. L'information de référence constituée d'une série de "0" et de "1" est stockée dans l'unité logique magnétique via l'orientation des aimantations de couches de référence d'éléments magnéto-résistifs. Les aimantations des couches de référence sont fixes y compris en présence d'un champ magnétique. En revanche, l'aimantation d'une seconde couche ferromagnétique de l'élément magnéto-résistif est libre. Elle peut changer d'état (de "0" à "1" ou inversement) en présence d'un champ magnétique. Sans champ magnétique, les aimantations des couches libres sont naturellement alignées de façon antiparallèle aux aimantations des couches de référence. C'est le champ magnétique dipolaire qui est à l'origine de cette configuration antiparallèle des aimantations. La comparaison entre l'entrée utilisateur et l'information de référence s'effectue alors en mesurant les résistances en série des éléments magnéto-résistifs avec et sans entrée utilisateur. Dans le cas d'une entrée utilisateur correspondant exactement à la séquence de référence, les champs magnétiques générés par le passage d'un courant dans les pistes conductrices ne provoquent pas de changement dans la configuration magnétique des éléments magnéto-résistifs et il n'y a donc pas de changement de la résistance en série mesurée. Dans le cas contraire, lorsqu'au moins une entrée utilisateur diffère de la référence, la configuration magnétique d'au moins un élément magnéto-résistif change par le passage d'une configuration des aimantations antiparallèle à une configuration parallèle des aimantations, et la résistance des éléments mesurés en série change. Ainsi c'est la résistance totale qui indique alors la correspondance ou non entre la séquence de référence et la séquence entrée par l'utilisateur.

L'intensité du courant dans la piste conductrice doit être suffisante pour générer le champ magnétique orientant la couche ferromagnétique, ce qui conduit à une consommation électrique élevée pour l'alimentation des pistes conductrices. De plus, la construction des éléments magnétorésistifs nécessite de nombreuses couches et conduits à de nombreuses opérations pour leur fabrication.

L'invention vise à fournir un circuit de vérification de clé qui soit simple à réaliser et peu consommateur d'énergie.

### Description de l'invention

Avec ces objectifs en vue, l'invention a pour objet un circuit de vérification d'informations binaires telles qu'une clé de sécurité pour un dispositif électronique, le circuit comportant des moyens de stockage pour mémoriser les informations binaires formées d'une série d'états binaires, un bus d'entrée pour présenter une clé candidate à comparer avec les informations binaires et des moyens de comparaison pour délivrer un signal d'autorisation lorsque la clé candidate correspond aux informations binaires, les moyens de stockage comprenant une pluralité d'éléments de mémorisation magnétiques, le circuit étant caractérisé en ce que les éléments magnétiques sont des croix de Hall, chaque croix comportant deux branches de polarisation l'une en regard de l'autre et dont l'une est reliée au bus d'entrée et l'autre est connectée à un pôle de référence pour faire circuler un courant d'une branche de polarisation vers l'autre dans un sens fonction de l'un des états binaires de la clé candidate, chaque croix de Hall comportant en outre deux branches de lecture en regard l'une de l'autre et sensiblement perpendiculaires aux branches de polarisation, les croix de Hall étant connectées en série par leurs branches de lecture selon un chemin de lecture, chaque croix de Hall soit recevant un champ magnétique, soit comportant un moment magnétique propre, le moment ou le champ magnétique étant orienté perpendiculairement au plan de la croix défini par les branches et dans un sens lié aux états binaires des informations, les moyens de comparaison étant connectés entre les extrémités du chemin de lecture.

On entend par bus d'entrée une pluralité de conducteurs parallèles les uns aux autres et aptes à faire circuler un courant entre les branches de polarisation dans un sens ou dans l'autre. Naturellement, la circulation du courant s'effectue à partir ou vers un pôle de référence auquel l'une des branches de polarisation est connectée. La circulation dans un sens code un premier état, alors que la circulation d'un courant dans l'autre sens code un deuxième état. Au niveau de chaque croix de Hall, un courant traversant les branches de polarisation va générer un effet Hall, du fait du champ ou du moment magnétique qui traverse la croix de Hall, de telle sorte qu'une tension est générée entre les branches de lecture. Les moyens de comparaison mesurent donc la somme des tensions de l'ensemble des croix, du fait qu'elles sont connectées en série par les branches de lecture. Le sens de la tension pour chaque croix dépend d'une part de l'orientation du champ ou du moment magnétique et de l'orientation du courant. On considère que l'orientation du champ ou du moment magnétique pour une croix code l'un des états binaires de la clé de sécurité. On oriente également le sens du courant en fonction de l'état binaire de la clé candidate correspondant à celui des informations binaires auquel la comparaison doit s'appliquer. Les tensions de lecture doivent être toutes dans le même sens pour que le résultat soit considéré comme positif.

La construction du circuit nécessite la réalisation d'un nombre réduit de couches, dont celle formant les croix de Hall. La fabrication du circuit est donc bien plus simple que dans l'art antérieur. Les couches peuvent être réalisées selon les techniques classiques de dépôt de film minces et de lithographie en usage en microélectronique.

Selon une caractéristique avantageuse, les croix comportent un moment magnétique propre et sont à effet Hall extraordinaire, avec une anisotropie magnétique perpendiculaire au plan des croix. Le moment magnétique est intrinsèque au matériau qui forme la croix de Hall. Il n'est donc pas nécessaire de prévoir un matériau de support particulier pour emmagasiner le moment magnétique. On simplifie ainsi la fabrication du circuit. L'anisotropie du matériau permet de déterminer l'orientation du moment magnétique.

De manière particulière, les moyens de comparaison comparent une tension de lecture mesurée entre les extrémités du chemin de lecture à un seuil prédéterminé, et délivrent le signal d'autorisation si la tension de lecture est supérieure au seuil prédéterminé. La vérification est positive lorsque toutes les tensions aux bornes de chaque croix sont dans le même sens et donc la tension totale est maximale.

Selon une disposition constructive, les croix de Hall sont déposées par exemple sur une couche de germination composée d'au moins un élément parmi le groupe comprenant le titane, le tantale, le chrome, l'or, le cuivre, le silicium, le palladium, le vanadium, le platine et un alliage ruthénium-chrome. Une telle couche permet l'accrochage des couches suivantes sur un substrat ou d'induire des propriétés physiques particulières pour les couches suivantes. Son épaisseur est de l'ordre du nanomètre jusqu'au micromètre.

Selon un perfectionnement, les croix de Hall sont recouvertes d'une couche de couverture pour leur protection. La couche de recouvrement est par exemple une couche de résine organique ou une couche métallique ou isolante qui assure une protection mécanique et chimique, contre l'oxydation par exemple.

De manière particulière, les croix de Hall sont réalisées dans un matériau métallique ou semiconducteur, le matériau étant ferromagnétique, antiferromagnétique ou ferrimagnétique. Dans le cas des alliages ferrimagnétiques, la croix de Hall peut ne pas comporter de moment magnétique macroscopique, même si un courant qui la traverse génère une tension par effet Hall extraordinaire. C'est en particulier le cas avec des alliages à base de métal de transition (Co, Fe, Ni) mélangé avec une terre rare (Tb, Dy, Gd, Ho). Pour une large gamme de concentration, les matériaux ferrimagnétiques sont par ailleurs peu sensibles à un champ magnétique extérieur. Il est donc difficile de modifier de manière frauduleuse la valeur stockée par la croix de Hall.

Le matériau des croix de Hall est par exemple une multicouche choisie parmi un groupe comprenant les couples [Co/Ni]x, [Co/Pt]x, [Co/Pd]x, [Fe/Pt]x et [Fe/Pd]x, [Co/Au]x, V/FeCo/MgO, ou Cr/FeCo/MgO, x étant le nombre de couples de couches d'éléments qui sont répétés.

Le matériau des croix de Hall peut autrement être un alliage binaire chimiquement ordonné choisi parmi le groupe comprenant CoPt, FePt, FePd, CoPt₃, Co₃Pt, CoPd₃ et Co₃Pd.

Dans une variante, le matériau des croix de Hall est un alliage pseudo-binaire choisi parmi le groupe comprenant le PtₓCo_{y} et FeₓPt_{y} en phase L¹₀ ou L¹₁, x et y étant les proportions respectives du premier et du deuxième élément de l'alliage.

Dans une autre variante, le matériau des croix de Hall est un alliage à base de FeCo incluant ou non des éléments choisis parmi le groupe comprenant Ni, Au, Cu, Pd, B, Ag, Cr, Ru et des terres rares parmi Dy, Tb, Gd, Ho dans une plage comprise entre environ 0% et 20% en pourcentage atomique.

### Brève description des figures

L'invention sera mieux comprise et d'autres particularités et avantages apparaîtront à la lecture de la description qui va suivre, la description faisant référence aux dessins annexés parmi lesquels :
- la figure 1 est une représentation schématique d'une croix de Hall utilisée dans l'invention ;
- la figure 2 est une représentation schématique d'un circuit selon l'invention ;
- les figures 3 et 4 sont des photographies par microscope Kerr d'un circuit réalisé conformément à l'invention, avec deux états d'aimantation différents ;
- la figure 5 est une série de photographies par microscope Kerr similaires à celles des figures 3 et 4 dans différents états d'aimantation successifs.

### DESCRIPTION DETAILLEE

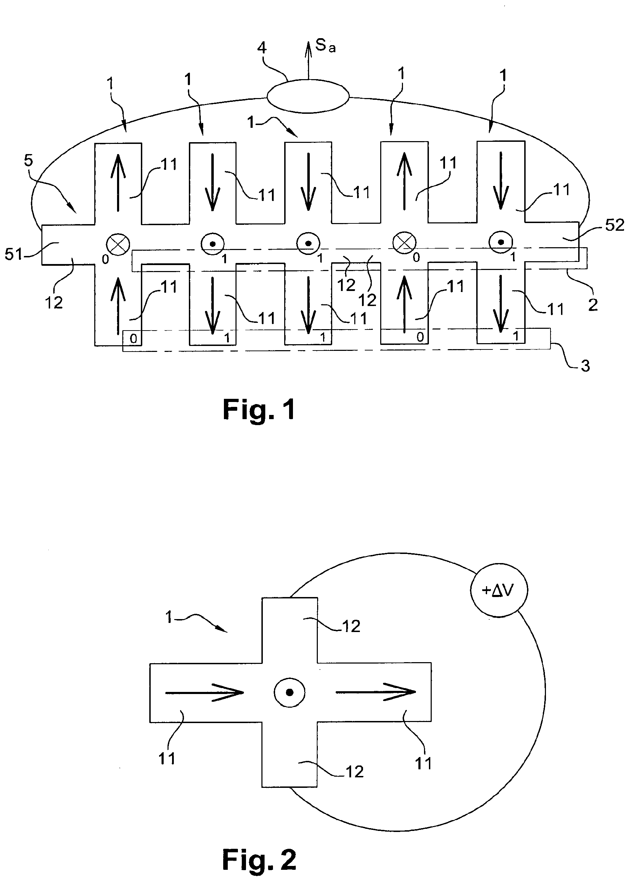

Un circuit de vérification d'informations binaires telles qu'une clé de sécurité pour un dispositif électronique est représenté sur les figures 1 et 2. Le circuit comporte des éléments de mémorisation 1 magnétiques sous la forme de croix de Hall à effet extraordinaire avec une anisotropie magnétique perpendiculaire au plan des croix, de manière à constituer des moyens de stockage pour mémoriser la clé de sécurité 2 formée d'une série d'états binaires. Un bus d'entrée formé par une pluralité de conducteurs 14 permet de présenter une clé candidate 3 à comparer avec la clé de sécurité 2. Le circuit comporte en outre des moyens de comparaison 4 pour délivrer un signal d'autorisation lorsque la clé candidate 3 correspond à la clé de sécurité 2.

En se référant à la figure 1, chaque croix de Hall 1 comporte deux branches de polarisation l'une en regard de l'autre, et deux branches de lecture 12 en regard l'une de l'autre et sensiblement perpendiculaires aux branches de polarisation 11. L'une des branches de polarisation 11 est reliée à l'un des conducteurs du bus d'entrée et l'autre est connectée à un pôle de référence 13 pour faire circuler un courant d'une branche de polarisation vers l'autre dans un sens fonction de l'un des états binaires de la clé candidate 3. Chaque croix de Hall 1 a une aimantation propre orientée perpendiculairement au plan de la croix défini par les branches. Le sens donné à l'aimantation est un codage de l'un des états binaires de la clé de sécurité 2.

Une pluralité de croix de Hall 1 sont connectées en série par leurs branches de lecture 12 de telle sorte que les branches de lecture 12 forment un chemin de lecture continu 5. Les moyens de comparaison 4 sont connectés entre les extrémités du chemin de lecture 5.

Les moyens de comparaison 4 comparent une tension de lecture mesurée entre les extrémités 51, 52 du chemin de lecture 5 à un seuil prédéterminé, et délivrent le signal d'autorisation Sa si la tension de lecture est supérieure au seuil prédéterminé.

Le circuit selon l'invention fait par exemple partie d'un circuit microélectronique qui l'intègre. Il peut être construit par exemple en superposition d'autres éléments du circuit microélectronique. En variante, il peut être intégré par différentes techniques de contact au sein d'un composant hybride. La forme du dispositif est définie par exemple par lithographie optique, électronique ou par nanoimpression, puis transférée sur le circuit en construction par gravure chimique, ionique ou plasma dans un film déposé, ou par remplissage d'endroit non protégés. On peut aussi envisager une fabrication par méthode additive ou par le dépôt de jet de matière. Le circuit microélectronique comprend d'autres unités, non représentées, permettant de contrôler le bus d'entrée ou dont l'accès est contrôlé par le signal d'autorisation Sa après la vérification de la clé de sécurité 2.

L'orientation de l'aimantation dans chaque croix de Hall 1 peut être réinscriptible ou non. L'écriture de l'information peut être réalisée par un champ magnétique extérieur appliqué localement ou non sur chaque croix, en présence de conditions favorisant le renversement d'aimantation locale par chauffage avec un courant électrique local, par gradient de température, par application d'une différence de potentielle, par application d'un champ électrique ou d'une contrainte mécanique, par l'absorption de photons (lumière) polarisés ou par transfert de spin.

### Exemple

Un circuit selon l'invention basé sur des alliages à base d'atome de terbium (Tb) et de cobalt (Co) avec différentes compositions a été réalisé. L'une des compositions permet de travailler à aimantation macroscopique nulle, c'est-à-dire que l'information stockée ne peut pas être modifiée sans chauffage par un champ magnétique extérieur. Le circuit comporte trois croix de Hall 1. Des tests d'écriture par chauffage et de lecture par effet Hall ont été effectués. Un microscope Kerr, sensible à la direction de l'aimantation, permet de suivre l'orientation de l'aimantation dans le circuit.

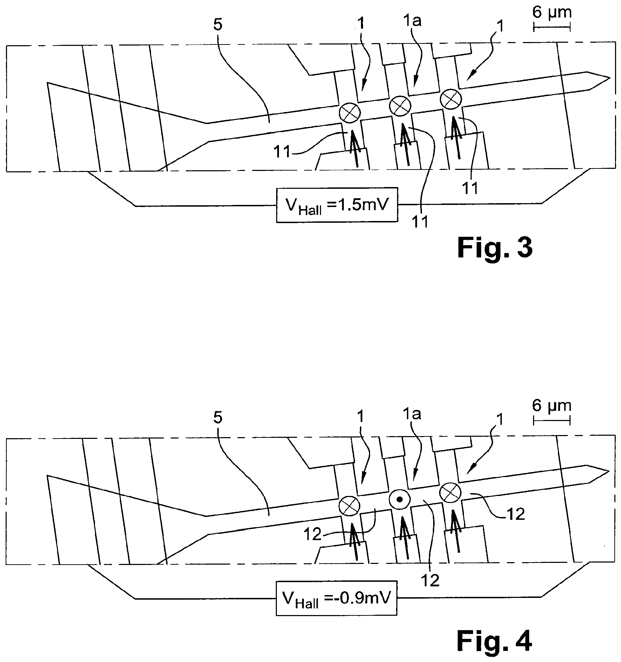

Sur le circuit dont l'image est montrée sur la figure 3, toutes les croix de Hall 1 sont aimantées selon la même orientation, selon la direction indiquée par le symbole des croix cerclées, codant ainsi une clé de sécurité 2 à trois états binaires « 000 ». Toutes les croix de Hall 1 ont le même niveau de gris. Toutes les croix sont traversées par un courant dans les branches de polarisation 11 dans le sens indiqué par les flèches i1, représentant une clé candidate 3 de trois états binaires « 000 ». La tension mesurée aux extrémités 51, 52 du chemin de lecture 5 est de 1,5 mV et est comparée à un seuil de 1,49 mV et les moyens de comparaison 4 délivrent le signal d'autorisation Sa.

Sur le même circuit que précédemment, dont l'image est montrée sur la figure 4, la croix de Hall centrale 1a a changé d'orientation d'aimantation, selon la direction indiquée par le symbole de point cerclé, codant ainsi une clé de sécurité 2 à trois états binaires « 010 ». La croix de Hall centrale 1a apparaît avec un niveau plus clair que les autres croix de Hall 1. Toutes les croix sont traversées par un courant dans les branches de polarisation 11 dans le sens indiqué par les flèches i2, représentant une clé candidate 3 de trois états binaires « 000 ». La tension mesurée aux extrémités 51, 52 du chemin de lecture 5 est de -0,9 mV et est comparée au seuil de 1,49 mV et les moyens de comparaison 4 ne délivrent aucun signal d'autorisation Sa. Il va de soi que le seuil dépend de facteurs liés à la conception du circuit, tels que le nombre de croix de Hall, leur taille, la nature des matériaux ou l'amplitude du moment magnétique.

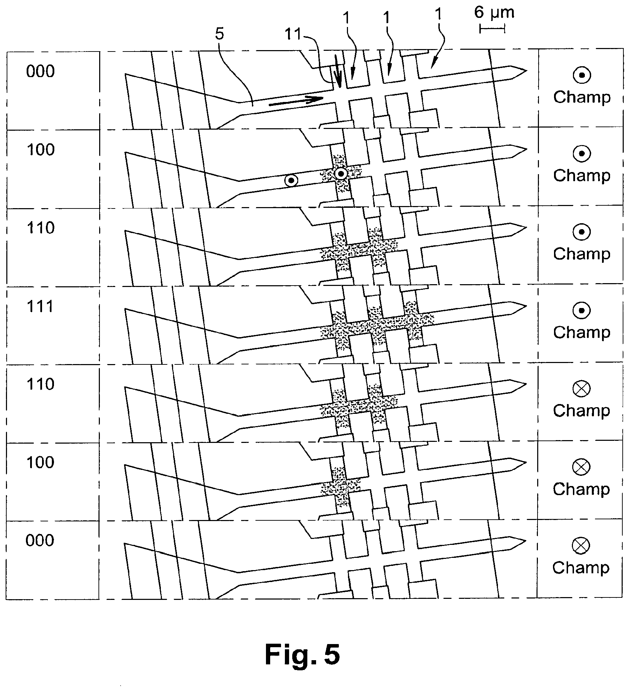

La figure 5 représente un tableau d'images prises à l'aide d'un microscope Kerr correspondant à une série d'écritures de différentes informations sur un circuit à trois croix de Hall 1. Le processus d'écriture est basé sur le passage d'un courant électrique à la fois dans le chemin de lecture 5 commun à toutes les croix de Hall 1 et dans les branches de polarisation 11 correspondant à la croix de Hall 1 dont on veut renverser l'aimantation. Le courant chauffe localement la croix de Hall 1 voulue, ce qui permet à un champ magnétique appliqué perpendiculairement au plan de croix de Hall 1 de renverser l'aimantation. Là où les deux courants ne passent pas simultanément, la température est trop basse pour aider le champ à renverser l'aimantation et donc l'aimantation n'est pas perturbée. Ici à partir de la clé de sécurité « 000 », comme montré par le fait que toutes les croix de Hall 1 sont grises, on passe à « 100 » en injectant du courant dans la croix 1 de gauche. Celle-ci-apparaît blanche sur l'image suivante, ce qui signifie que son aimantation est maintenant dirigée vers le haut. La série d'écritures montre que chaque croix de Hall 1 peut être aimantée dans un sens, puis dans l'autre. Dans cette série d'écritures, l'écriture se fait sous un champ magnétique de 20 mT.

L'invention n'est pas limitée au mode de réalisation qui vient d'être décrit à titre d'exemple. L'aimantation pourrait être conférée à une couche sous-jacente aux croix de Hall. Dans ce cas, la croix de Hall sera composée d'un matériau métallique ou semiconducteur permettant de réaliser une mesure d'effet Hall dite normale.

## Revendications

1. Circuit de vérification d'informations binaires telles qu'une clé de sécurité (2) pour un dispositif électronique,
le circuit comportant des moyens de stockage pour mémoriser les informations binaires (2) formées d'une série d'états binaires,
les moyens de stockage comprenant des croix de Hall (1) formant une pluralité d'éléments de mémorisation (1) magnétiques, chaque croix de Hall (1) comportant :
• deux branches de polarisation (11) l'une en regard de l'autre,
• deux branches de lecture (12) en regard l'une de l'autre et sensiblement perpendiculaires aux branches de polarisation (11),
chaque croix de Hall (1) soit recevant un champ magnétique, soit comportant un moment magnétique propre, le moment ou le champ magnétique étant orienté perpendiculairement au plan de la croix défini par les branches (11, 12) et dans un sens lié aux états binaires des informations (2),
le circuit comporte un bus d'entrée comportant une pluralité de conducteurs (14) parallèles les uns aux autres et aptes à faire circuler un courant entre les branches de polarisation (11) dans un sens ou dans l'autre, l'une parmi les deux branches de polarisation (11) étant reliée au bus d'entrée, toutes les croix de Hall (1) sont connectées en série par leurs branches de lecture (12) selon un chemin de lecture (5), **caractérisé en ce que** le bus d'entrée est adapté à présenter une clé candidate (3) à comparer avec les informations binaires (2),
**en ce que** le circuit comporte des moyens de comparaison (4) adaptés à délivrer un signal d'autorisation (Sa) électrique lorsque la clé candidate (3) correspond aux informations binaires (2),
**en ce que** l'autre parmi les deux branches de polarisation (11) est connectée à un pôle de référence (13) pour faire circuler un courant d'une branche de polarisation (11) vers l'autre branche de polarisation (11) dans un sens fonction de l'un des états binaires de la clé candidate (3),
**en ce que** les moyens de comparaison (4) sont connectés entre les extrémités (51, 52) du chemin de lecture (5),
**en ce que** le chemin de lecture est continu (5).

2. Circuit selon la revendication 1, **caractérisé en ce que** les croix (1) comportent un moment magnétique propre et sont à effet Hall extraordinaire, avec une anisotropie magnétique perpendiculaire au plan des croix (1).

3. Circuit selon l'une des revendications 1 ou 2, **caractérisé en ce que** les moyens de comparaison (4) sont adaptés à :
• mesurer entre les extrémités (51, 52) du chemin de lecture (5) une somme des tensions de l'ensemble des croix de Hall (1) pour obtenir une tension de lecture,
• comparer cette tension de lecture à un seuil prédéterminé, et
• délivrer le signal d'autorisation (Sa) électrique si la tension de lecture est supérieure au seuil prédéterminé.

4. Circuit selon l'une des revendications précédentes, **caractérisé en ce que** les croix de Hall (1) sont déposées sur une couche de germination composée d'au moins un élément parmi le groupe comprenant le titane, le tantale, le chrome, l'or, le cuivre, le silicium, le palladium, le vanadium, le platine et un alliage ruthénium-chrome.

5. Circuit selon l'une des revendications précédentes, **caractérisé en ce que** les croix de Hall (1) sont recouvertes d'une couche de couverture pour leur protection.

6. Circuit selon l'une des revendications précédentes, **caractérisé en ce que** les croix de Hall (1) sont réalisées dans un matériau métallique ou semiconducteur, le matériau étant ferromagnétique, antiferromagnétique ou ferrimagnétique.

7. Circuit selon la revendication 6, **caractérisé en ce que** le matériau des croix de Hall (1) est une multicouche choisie parmi un groupe comprenant les couples [Co/Ni]x, [Co/Pt]x, [Co/Pd]x, [Fe/Pt]x et [Fe/Pd]x, [Co/Au]x, V/FeCo/MgO, ou Cr/FeCo/MgO, x étant le nombre de couples de couches d'éléments qui sont répétés.

8. Circuit selon la revendication 6, **caractérisé en ce que** le matériau des croix de Hall (1) est un alliage binaire chimiquement ordonné choisi parmi le groupe comprenant CoPt, FePt, FePd, CoPt₃, Co₃Pt, CoPd₃ et Co₃Pd.

9. Circuit selon la revendication 6, **caractérisé en ce que** le matériau des croix de Hall (1) est un alliage pseudo-binaire choisi parmi le groupe comprenant le PtₓCo_{y} et FeₓPt_{y} en phase L¹₀ ou L¹₁, x et y étant les proportions respectives du premier et du deuxième élément de l'alliage.

10. Circuit selon la revendication 6, **caractérisé en ce que** le matériau des croix de Hall (1) est un alliage à base de FeCo incluant ou non des éléments choisis parmi le groupe comprenant Ni, Au, Cu, Pd, B, Ag, Cr, Ru et des terres rares parmi Dy, Tb, Gd, Ho dans une plage comprise entre environ 0% et 20% en pourcentage atomique.

11. Circuit selon la revendication 6, **caractérisé en ce que** tous les croix de Hall (1) sont formés sur une seule couche.

## Patentansprüche

1. Schaltung zur Überprüfung von binären Informationen wie z. B. einem Sicherheitsschlüssel (2) für eine elektronische Vorrichtung,
wobei die Schaltung Speichermittel umfasst, um die binären Informationen (2) aufzuzeichnen, die in einer Reihe von binären Zuständen gebildet werden,
wobei die Speichermittel ein Hall-Kreuz (1) umfassen, das eine Vielzahl von magnetischen Aufzeichnungselementen (1) bildet, wobei jedes Hall-Kreuz (1) Folgendes umfasst:
- zwei Polarisierungsschenkel (11), der eine gegenüber dem anderen,
- zwei Leseschenkel (12), einer gegenüber dem anderen, und im Wesentlichen senkrecht zu den Polarisierungsschenkeln (11),
wobei jedes Hall-Kreuz (1) entweder ein Magnetfeld aufnimmt oder ein eigenes Magnetmoment umfasst, wobei das magnetische Moment oder das magnetische Feld senkrecht zur Ebene des Kreuzes ausgerichtet ist, das durch die Schenkel (11, 12) definiert ist, und in einer Richtung, die mit den binären Zuständen der Informationen (2) verbunden ist,
wobei die Schaltung einen Eingangsbus umfasst, umfassend eine Vielzahl von Leitern (14), die zueinander parallel und ausgelegt sind, um einen Strom zwischen den Polarisierungsschenkeln (11) in der einen oder der anderen Richtung zirkulieren zu lassen, wobei einer von den zwei Polarisierungsschenkeln (11) mit dem Eingangsbus verbunden ist,
wobei alle Hall-Kreuze (1) in Reihe durch ihre Leseschenkel (12) gemäß einem Leseweg (5) verbunden sind,
**dadurch gekennzeichnet, dass** der Eingangsbus ausgelegt ist, um einen Kandidatenschlüssel (3) darzustellen, um ihn mit den binären Informationen (2) zu vergleichen,
dadurch, dass die Schaltung Vergleichsmittel (4) umfasst, die ausgelegt sind, um ein elektrisches Autorisierungssignal (Sa) zu liefern, wenn der Kandidatenschlüssel (3) den binären Informationen (2) entspricht,
dadurch, dass der andere der zwei Polarisierungsschenkel (11) mit einem Referenzpol (13) in Kontakt steht, um einen Strom von einem Polarisierungsschenkel (11) hin zum anderen Polarisierungsschenkel (11) in einer Richtung je nach einem der binären Zustände des Schlüsselkandidaten (3) zirkulieren zu lassen,
dadurch, dass die Vergleichsmittel (4) zwischen den Enden (51, 52) des Lesewegs (5) verbunden sind,
dadurch, dass der Leseweg (5) kontinuierlich ist.

2. Schaltung nach Anspruch 1, **dadurch gekennzeichnet, dass** die Kreuze (1) ein eigenes magnetisches Moment umfassen und einen außergewöhnlichen Hall-Effekt aufweisen, mit einer magnetischen Anisotropie senkrecht zur Ebene der Kreuze (1) .

3. Schaltung nach einem der Ansprüche 1 oder 2, **dadurch gekennzeichnet, dass** die Vergleichsmittel (4) ausgelegt sind, um:
- zwischen den Enden (51, 52) des Lesewegs (5) eine Summe der Spannungen der Gesamtheit der Hall-Kreuze (1) zu messen, um eine Lesespannung zu erhalten,
- diese Lesespannung mit einem vorbestimmten Schwellwert zu vergleichen, und
- das elektrische Autorisierungssignal (Sa) zu liefern, wenn die Lesespannung höher als der vorbestimmte Schwellwert ist.

4. Schaltung nach einem der vorhergehenden Ansprüche, **dadurch gekennzeichnet, dass** die Hall-Kreuze (1) auf einer Keimschicht abgelegt sind, die aus mindestens einem Element aus der Gruppe zusammengesetzt ist, umfassend Titan, Tantal, Chrom, Gold, Kupfer, Silizium, Palladium, Vanadium, Platin und eine Ruthenium-Chrom-Legierung.

5. Schaltung nach einem der vorhergehenden Ansprüche, **dadurch gekennzeichnet, dass** die Hall-Kreuze (1) mit einer Deckschicht für ihren Schutz bedeckt sind.

6. Schaltung nach einem der vorhergehenden Ansprüche, **dadurch gekennzeichnet, dass** die Hall-Kreuze (1) aus einem metallischen oder Halbleitermaterial hergestellt sind, wobei das Material ferromagnetisch, antiferromagnetisch oder ferromagnetisch ist.

7. Schaltung nach Anspruch 6, **dadurch gekennzeichnet, dass** das Material der Hall-Kreuze (1) eine Multischicht ist, ausgewählt aus der Gruppe, umfassend die Paare [Co/Ni]x, [Co/Pt]x, [Co/Pd]x, [Fe/Pt]x und [Fe/Pd]x, [Co/Au]x, V/FeCo/MgO oder Cr/FeCo/MgO, wobei x die Anzahl der Paare von Elementen ist, die wiederholt werden.

8. Schaltung nach Anspruch 6, **dadurch gekennzeichnet, dass** das Material der Hall-Kreuze (1) eine chemisch geordnete binäre Legierung ist, ausgewählt aus der Gruppe, umfassend CoPt, FePt, FePd, CoPt₃, Co₃Pt, CoPd₃ und Co₃Pd.

9. Schaltung nach Anspruch 6, **dadurch gekennzeichnet, dass** das Material der Hall-Kreuze (1) eine pseudobinäre Legierung ist, ausgewählt aus der Gruppe, umfassend PtₓCo_{y} und FeₓPt_{y} in der Phase L¹₀ oder L¹₁, wobei x und y entsprechende Proportionen des ersten und des zweiten Elements der Legierung sind.

10. Schaltung nach Anspruch 6, **dadurch gekennzeichnet, dass** das Material der Hall-Kreuze (1) eine Legierung auf der Grundlage von FeCo ist, darin eingeschlossen oder nicht Elemente, ausgewählt aus der Gruppe, umfassend Ni, Au, Cu, Pd, B, Ag, Cr, Ru und Seltenerden aus Dy, Tb, Gd, Ho in einem Bereich, der zwischen ungefähr 0 % und 20 % in Atomprozent liegt.

11. Schaltung nach Anspruch 6, **dadurch gekennzeichnet, dass** alle Hall-Kreuze (1) auf einer einzigen Schicht gebildet sind

## Claims

1. Circuit for verifying binary information such as a security key (2) for an electronic device,
the circuit comprising storage means for memorising the binary information (2) formed by a series of binary states,
the storage means comprising Hall crosses (1) forming a plurality of magnetic memorisation elements (1), each Hall cross (1) comprising:
- two polarisation branches (11) facing one another,
- two reading branches (12) facing one another and substantially perpendicular to the polarisation branches (11),
each Hall cross (1) either receiving a magnetic field or comprising its own magnetic moment, the moment or the magnetic field being oriented perpendicularly to the plane of the cross defined by the branches (11, 12) and, in one direction, linked to the binary states of the information (2),
the circuit comprises an input bus comprising a plurality of conductors (14) parallel to each other and suitable for circulating a current between the polarisation branches (11) in one direction or in the other, one of the two polarisation branches (11) being connected to the input bus,
all of the Hall crosses (1) are connected in series by their reading branches (12) along a reading path (5),
**characterised in that** the input bus is suitable for having a candidate key (3) to be compared to the binary information (2),
**in that** the circuit comprises comparison means (4) suitable for delivering an electric authorisation signal (Sa) when the candidate key (3) corresponds to the binary information (2),
**in that** the other of the two polarisation branches (11) is connected to a reference pole (13) in order to circulate a current from one polarisation branch (11) to the other polarisation branch (11) in a direction that is dependent on one of the binary states of the candidate key (3),
**in that** the comparison means (4) are connected between the ends (51, 52) of the reading path (5),
**in that** the reading path is continuous (5).

2. Circuit according to claim 1, **characterised in that** the crosses (1) comprise their own magnetic moment and have an extraordinary Hall effect, with a magnetic anisotropy perpendicular to the plane of the crosses (1) .

3. Circuit according to one of claims 1 and 2, **characterised in that** the comparison means (4) are suitable for:
- measuring, between the ends (51, 52) of the reading path (5), a sum of the voltages of all the Hall crosses (1) in order to obtain a reading voltage,
- comparing this reading voltage to a predetermined threshold, and
- delivering an electric authorisation signal (Sa) if the reading voltage is greater than the predetermined threshold.

4. Circuit according to one of the previous claims, **characterised in that** the Hall crosses (1) are deposited on a germination layer composed of at least one element out of the group comprising titanium, tantalum, chromium, gold, copper, silicon, palladium, vanadium, platinum and a ruthenium-chromium alloy.

5. Circuit according to one of the previous claims, **characterised in that** the Hall crosses (1) are coated with a covering layer for their protection.

6. Circuit according to one of the previous claims, **characterised in that** the Hall crosses (1) are made from a metal or semiconductor material, the material being ferromagnetic, antiferromagnetic or ferrimagnetic.

7. Circuit according to claim 6, **characterised in that** the material of the Hall crosses (1) is a multilayer chosen from the group comprising the pairs [Co/Ni]x, [Co/Pt]x [Co/Pd]x, [Fe/Pt]x and [Fe/Pd]x, [Co/Au]x, V/FeCo/MgO, or Cr/FeCo/MgO, x being the number of pairs of layers of elements that are repeated.

8. Circuit according to claim 6, **characterised in that** the material of the Hall crosses (1) is a chemically ordered binary alloy chosen from the group comprising CoPt, FePt, FePd, CoPt₃, Co₃Pt, CoPd₃ and Co₃Pd.

9. Circuit according to claim 6, **characterised in that** the material of the Hall crosses (1) is a pseudobinary alloy chosen from the group comprising PtₓCo_{y} and FeₓPt_{y} in the L¹₀ or L¹₁ phase, x and y being the respective proportions of the first and of the second element of the alloy.

10. Circuit according to claim 6, **characterised in that** the material of the Hall crosses (1) is an alloy containing FeCo and including or not including elements chosen from the group comprising Ni, Au, Cu, Pd, B, Ag, Cr, Ru and rare Earths chosen from Dy, Tb, Gd, Ho in a range between approximately 0% and 20% in terms of atomic percent.

11. Circuit according to claim 6, **characterised in that** all the Hall crosses (1) are formed on a single layer.
